(19) Europäisches Patentamt
European Patent Office
Office européen des brevets

(11) **EP 3 616 222 B1**

(12) **EUROPEAN PATENT SPECIFICATION**

(45) Date of publication and mention
of the grant of the patent:
**13.03.2024 Bulletin 2024/11**

(21) Application number: **18720551.3**

(22) Date of filing: **18.04.2018**

(51) International Patent Classification (IPC):
*H01F 41/18* ^(2006.01)          *C23C 14/35* ^(2006.01)
*C23C 14/50* ^(2006.01)

(52) Cooperative Patent Classification (CPC):
**H01F 41/183; C23C 14/067; C23C 14/14;
C23C 14/345; C23C 14/505; C23C 14/568;
H01F 41/18**

(86) International application number:
**PCT/EP2018/059943**

(87) International publication number:
**WO 2018/197305 (01.11.2018 Gazette 2018/44)**

(54) **SOFT MAGNETIC MULTILAYER DEPOSITION APPARATUS AND METHOD OF MANUFACTURING**

ABSCHEIDUNGSVORRICHTUNG FÜR WEICHMAGNETISCHE MEHRFACHSCHICHT UND HERSTELLUNGSVERFAHREN

DISPOSITIF DE DÉPÔT DE MULTICOUCHE MAGNÉTIQUE DOUCE ET MÉTHODE DE PRÉPARATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.04.2017 CH 5622017**

(43) Date of publication of application:
**04.03.2020 Bulletin 2020/10**

(73) Proprietor: **Evatec AG
9477 Trübbach (CH)**

(72) Inventors:
• **FALUB, Claudiu Valentin
8051 Zürich (CH)**

• **BLESS, Martin
9479 Trübbach (CH)**

(74) Representative: **Troesch Scheidegger Werner AG
Schwäntenmos 14
8126 Zumikon (CH)**

(56) References cited:
EP-A1- 1 111 087          EP-A1- 1 473 742
WO-A1-02/085090          WO-A1-2009/053435
JP-A- S62 284 076          US-A- 5 618 388
US-A1- 2004 182 701          US-A1- 2009 134 011

**Description**

There exists the need for miniaturization of integrated induction-based devices as e.g. of transformers, induction coils etc. operating at very high frequencies up to several GHz.

From the US 7 224 254 it is known to sputter deposit thin, soft magnetic material layers of different materials on a substrate by means of a faced target arrangement.

From US 2009/0134011 an apparatus for sputter deposition of a directional, soft magnetic material layer on substrates is known. Thereby substrates on the outside of a cylindrical basked that can pivot around an axis pass targets constituted of conventional magnetron targets. A screening system in the form of a collimator is provided between each target and the basket.

From the US 5 618 388 it is known to move both, a deposition zone and a reaction zone relative to the periphery of a substrate carrier. The respective deposition device may be a magnetron sputter deposition device. Ni or Fe may be sputter-deposited.

The present invention departs from the recognition, that by stacking very thin layers of at least two soft magnetic materials, an overall behavior of the layer stack results with improved characteristics for high frequency magnetic applications thereby allowing further reducing the size of inductive micro devices on substrates and improved highfrequency behavior.

For industrial applications, techniques should be available to deposit efficiently and well-controlled stacks of very thin layers of soft magnetic materials.

This is realized by the soft magnetic material multilayer deposition apparatus according to the present invention and as defined by the wording of claim 1.

It comprises a circular inner space vacuum transport chamber about an axis. Thereby the term "circular" is to be understood as including a polygon approximation of the respective circles. As will be addresses later, the circular inner space may be annular shaped or cylindrical. The axial extent if the circular inner space relative to its radial extent may be large or small.

Along a plane perpendicular to the axis, a circular arrangement of a multitude of substrate carriers is provided, in the inner space and coaxially to the axis.

Along a plane perpendicular to the axis, there is provided a circular arrangement of substrate treatment stations, the stations thereof treatment-operative into the inner space.

There is further provided a rotational drive operationally coupled between the circular arrangement of the multitude of substrate carriers and the circular arrangement of treatment stations, so as to establish a relative rotation between the circular arrangement of the multitude of substrate carriers and the circular arrangement of treatment stations.

The circular arrangement of the multitude of substrate carriers and the circular arrangement of treatment stations are mutually aligned. Either they are aligned as being provided along a common plane perpendicular to the axis, or they are aligned in that the two circular arrangements are arranged along equal radius circles with respect to the axis.

Each substrate carrier is configured to accommodate a substrate so that one of the extended surfaces - that surface to be treated by the apparatus - of each of the substrates subsequently faces the stations of the arrangement of treatment stations as the relative rotation of the two circular arrangements is established by the rotational drive.

Depending on the specific technique of depositing the layer stack and of its overall structure, the arrangement of treatment stations may comprise different layer deposition stations e.g. for reactive or non- reactive sputter deposition of electrically conductive or of dielectric materials, etching stations etc.

Specifically, and according to the invention, the arrangement of substrate treatment stations comprises at least one first and at least one second sputter deposition station, each with a single target.

The first sputter deposition station has a first target of a first soft magnetic material. Thus, the first soft magnetic material to be deposited as layer material of a very thin layer on the substrates and is sputtered from solid single target and not reactively. If the first target is of a mixed material, e.g. of two or more than two ferromagnetic elements and/or comprises one or more than one non-ferromagnetic element, sputter deposition from the solid of a single target allows a highly accurate control of the stoichiometry of the deposited first material and of accurate stability of its stoichiometry over time. Dependent on the characteristics of this first soft magnetic material with respect to sputtering, DC-, pulsed DC- including HIPIMS- or Rf- single or multiple frequency supplied sputtering is applied.

The second sputter deposition station has a target of a second soft magnetic material, different from the first soft magnetic material.

Please note, that under a most generic aspect, "different" may also mean the same material composition but with different stoichiometry.

The second soft magnetic material to be deposited as material of a very thin layer on the substrates is as well sputtered from single target solid and not reactively. If the second target is of a mixed material, e.g. of two or more than two ferromagnetic elements and/or comprises one or more than one non-ferromagnetic elements, sputter deposition from the single target solid allows a highly accurate control of the stoichiometry of the deposited second material and of accurate stability of its stoichiometry over time. Dependent on the characteristics of this second soft magnetic material with respect to sputtering, DC-, pulsed DC- including HIPIMS- or Rf- single or multiple frequency supplied sputtering is applied.

The apparatus further comprises a control unit operationally coupled to the stations of the arrangement of treating stations and to the rotational drive. The control unit is configured to control the first and the second sputter deposition stations so as to be continuously sputter deposition enabled towards the arrangement of the multitude of substrate carriers, at least during more than one 360° relative revolutions of the circular arrangement of the multitude of substrate carriers relative to the circular arrangement of treatment stations, about the addressed axis, the addressed revolutions directly succeeding one another.

Further, the control unit is configured to control the rotational drive for continuous relative rotation at a constant angular velocity with respect to the axis for at least some of the more than one 360° revolutions directly succeeding one another.

Thus, sputter operation of at least the first and the second sputter deposition stations and respective sputtering towards the arrangement of the multitude of substrate carriers is not interrupted during the more than one relative revolutions of the arrangement of the multitude of substrate carriers with respect to the arrangement of treatment stations. Thereby any transitional states of sputtering effect are avoided as may occur by intermittently enabling and disabling sputter deposition.

In one embodiment of the apparatus according to the invention, the circular inner space is annular and the arrangement of said multitude of substrate carriers or the arrangement of treatment stations is mounted to the radially outer circular surface of the annular or to the top surface or to the bottom surface of the annular inner space.

In one embodiment of the apparatus according to the invention, the circular inner space is annular and the arrangement of said multitude of substrate carriers or said arrangement of treatment stations is mounted to the radially inner circular surface of said annular inner space.

In one embodiment of the apparatus according to the invention, the circular inner space is cylindrical and the arrangement of the multitude of substrate carriers or the arrangement of treatment stations is mounted to the circular surface, which is the surrounding surface of the cylindrical inner space, or to the bottom surface or to the top surface of the cylindrical inner space.

In one embodiment of the apparatus according to the invention, the arrangement of treatment stations is stationary and the arrangement of the multitude of substrate carriers is rotatable. It is nevertheless also possible to keep the arrangement of the multitude of substrate carriers stationary and to rotate the arrangement of treatment stations.

In one embodiment of the apparatus according to the invention, the first target comprises or consists of one or more than one of the elements of the group Fe, Ni, Co and the second target comprises or consists of one or more than one element out of the group Fe, Ni, Co.

Please note that the two target materials according to the invention are different:
Thus, if the two targets consist each of one single of the addressed elements, then the targets are of different elements out of the addressed group.

If the targets consist each of two of the addressed elements, they consist of different couples out of the addressed group or they consist of the same couples out of the addressed group but at different stoichiometry.

If the targets consist each of all three elements of the addressed group, then they are different with respect to stoichiometry.

In one embodiment of the apparatus according to the invention, the first target consists of one or more than one element out of the group Fe, Ni, Co and of at least one non-ferromagnetic element and/or the second target consists of one or more than one element out of the group Fe, Ni, Co and of at least one non-ferromagnetic element.

Thus, the difference of the materials of the first and second targets may be based on difference of the one or more than one ferromagnetic elements as addressed above and/ or on the difference with respect to the one or more than one non-ferromagnetic elements, including differences just based on different stoichiometry.

In one embodiment of the apparatus according to the invention, the at least one non-ferromagnetic element just addressed is at least one element out of the groups IIIA, IVB and VB of the periodic system (according to groups 13,4,5 of IUAPC).

In one embodiment of the apparatus according to the invention, the at least one non-ferromagnetic element just addressed is at least one element out of the group B, Ta, Zr.

In one embodiment of the apparatus according to the invention, the first target comprises or consists of one or more than one element of the group Fe, Ni, Co and the second target comprises or consists of one or more than one element of the group Fe, Ni, Co and further comprising at least one further sputter deposition station neighboring the first and /or the second sputter deposition station and having a target of at least one non ferromagnetic element.

In one embodiment of the just addressed embodiment, the at least one non-ferromagnetic element of the target of the further sputter deposition station is at least one element out of the groups IIIA, IVB and VB of the periodic system (according to groups 13,4,5 of IUAPC).

In one embodiment of the just addressed embodiment the at least one non-ferromagnetic element is at least one out of the group B, Ta, Zr.

During the more than one 360∘ relative revolutions of the arrangement of the multitude of substrate carriers with respect to the arrangement of treatment stations and about the addressed axis, the substrates are coated more than one time with very thin layers at least of the first and of the second soft magnetic materials. If the arrangement of substrate treatment stations does not comprise an additional treatment station between the first and second sputter deposition stations -also called sputtering stations- or the substrate treatment by such an additional treatment station is disabled during the addressed revolutions, very thin layers of the first and of the second soft magnetic materials are deposited directly one upon the other.

If further the arrangement of treatment stations does not comprise further treatment stations, treatment-enabled during the addressed revolutions, a stack of first and second soft magnetic material layers is realized on the substrates. The number of very thin layers of the stack is governed by the number of 360° relative revolutions. Clearly more than one first sputter deposition station and more than one second sputter deposition station may be provided in the arrangement of treatment stations, so that more than two first and second soft magnetic material layers are deposited on the substrates per 360°-revolution directly one upon the other or separate by at least one very thin layer, deposited by at least one further layer depositing station of the arrangement of treatment stations and deposition-enabled as well during the more than one 360∘ relative revolutions.

Per the addressed more than one 360∘ revolutions, directly subsequent to depositing a respective very thin layer of one of the first and/or of the second ferromagnetic target materials as was addressed, a very thin layer of a non-ferromagnetic material may be deposited by a further sputter deposition station which is deposition-enabled like the first and second sputter deposition stations.

Thus, one of these relative revolutions may be performed at a first constant angular velocity, another at a different constant velocity. Combined with controlling the first and the second sputter deposition stations to continuously sputter at least during the more than one directly succeeding 360° relative revolutions of the arrangement of the multitude of substrate carriers about the addressed axis, transitional, hard to control deposition behaviors are avoided.

In one embodiment of the apparatus according to the invention, the control unit is configured to control sputtering power of at least the first and of at least the second sputter deposition stations in dependency of an exposure time each of said substrate carriers is exposed to said first and to said second sputter deposition stations respectively, so as to sputter deposit by each of said first and second sputter deposition stations a layer of said first and of said second materials, respectively, of a respectively desired thickness $d_1, d_2$.

In one embodiment of the embodiment just addressed the control unit is configured to perform control so that there is valid:

$$10 \text{ nm} \geq (d_1, d_2) \geq 0.1 \text{ nm.}$$

In one embodiment the control unit is configured to perform control so that there is valid:

$$5 \text{ nm} \geq (d_1, d_2,) \geq 0.1 \text{ nm.}$$

In one embodiment the control unit is configured to perform control so that there is valid:

$$1 \text{ nm} \geq (d_1, d_2,) \geq 0.1 \text{ nm.}$$

In one embodiment the control unit is configured to perform control so that there is valid:

$$0.5 \text{ nm} \geq (d_1, d_2,) \geq 0.1 \text{ nm}$$

or

$$0.5 \text{ nm} \geq (d_1, d_2,) \geq 0.2 \text{ nm.}$$

In one embodiment the control unit is configured to perform control so that the thicknesses $d_1$ and $d_2$ are equal.

In one embodiment the control unit is configured to perform control so that $d_1$ and $d_2$ are 1 nm.

In one embodiment the control unit is configured to perform control so that at last one of $d_1$ and $d_2$ is < 1 nm.

In one embodiment the control unit is configured to perform control so that there is valid at least one of:

$$0.1 \; nm \; \leq \; (d_1, d_2) \; \leq \; 3 \; nm$$

$$0.3 \; nm \; \leq \; (d_1, d_2) \; \leq \; 2 \; nm$$

$$0.5 \; nm \; \leq \; (d_1, d_2) \; \leq \; 1.5 \; nm.$$

In one embodiment the control unit is configured to perform control so that the first and second layers reside directly one upon the other.

In one embodiment the first sputtering station is constructed to deposit FeCoB and the second sputtering station is constructed to deposit CoTaZr.

In one embodiment the control unit is configured to perform control so that the substrate carriers repeatedly pass the first and the second sputtering stations a multitude of times.

In one embodiment of the apparatus according to the invention, the arrangement of treatment stations comprises at least one further layer deposition station. The control unit is on one hand configured to control the further layer deposition station so as to continuously deposit at least during the more than one 360° revolutions. The control unit is further configured to control the material deposition rate of the further layer deposition station, in dependency of an exposure time each of the substrate carriers is exposed to the further layer deposition station, so that, by the further layer deposition station, a layer of a desired thickness $d_3$ is deposited. Thereby and in a good embodiment the addressed further layer deposition station is a sputter deposition station for a non- ferromagnetic material or element as was addressed above.

In one embodiment of the apparatus according to the invention, there the control unit is configured to perform control so that for the desired thicknesses, $d_3$, there is valid:

$$10 \; nm \; \geq \; (d_3) \; \geq \; 0.1 \; nm.$$

Thereby in one embodiment the control unit is configured to perform control so that there is valid

$$5 \; nm \; \geq \; d_3 \; \geq \; 2 \; nm.$$

In one embodiment of the apparatus according to the invention, the apparatus comprises more than one of the first sputter deposition stations.

In one embodiment of the apparatus according to the invention, the apparatus comprises more than one of the second sputter deposition stations.

In one embodiment of the apparatus according to the invention, the first and the second sputter deposition stations are a pair of neighboring stations along the inner space of the vacuum transport chamber.

In one embodiment of the apparatus according to the invention, comprising a multitude of the just addressed pairs, the first and second sputter deposition stations are arranged alternatingly.

In one embodiment of the apparatus according to the invention, the first and the second sputter deposition stations are two stations of a group of more than two-layer deposition stations, the layer deposition stations of the group are provided along the inner space one neighboring the other, and the stations of the group are simultaneously deposition-activated by control of the control unit.

Thus, there may be provided e.g. one further layer deposition station just ahead the first sputter deposition station and/or between the first and second sputter deposition station and/or just following the second sputter deposition station, considered in one direction of relative rotation of the arrangement of the multitude of substrate carriers with respect to the arrangement of treatment stations. All station members of the group are simultaneously deposition-activated as controlled by the controller unit.

In one embodiment of the apparatus according to the invention, the apparatus comprises more than one of the groups and/or comprises different of the groups.

Thus, e.g. multiple three- station groups may be provided and / or groups with different numbers of stations and /or with different stations.

In one embodiment of the apparatus according to the invention, the arrangement of substrate treatment stations comprises at least one further sputter deposition station configured to sputter deposit a further material on or towards the substrates or substrate holders.

In one embodiment of the apparatus according to the invention, the addressed material is a non-magnetic metal or a non-magnetic metal alloy or a dielectric material.

The dielectric material may e.g. be aluminum oxide, silicon oxide, tantalum oxide, silicon nitride, aluminum nitride or the respective carbides, oxi-carbides, nitro-carbides etc.

In one embodiment of the apparatus according to the invention, the control unit is configured to controllably enable and disable treatment of the substrates by selected ones or by all of said treatment stations. Selected disabling of treatment stations of the arrangement of substrate treatment stations including the first and the second sputter deposition stations may be applied e.g. for loading substrates to and/or unloading substrates from the apparatus, thereby maintaining overall treatment of all substrates equal.

Disabling and enabling substrate treatment by the respective stations may be performed by shutters, closing or opening the treatment connection from the stations to the substrate carriers and /or by switching on and off the electrical supply to the respective stations. Making use of shutters avoids switching transitional behaviors.

In one embodiment of the apparatus according to the invention the control unit is configured to control the rotational drive for continuous relative rotation at a constant angular velocity with respect to the axis for at least one of said more than one 360∘ relative revolutions directly succeeding one another and to inverse direction of revolution of the rotational drive. By inverting relative rotational or revolution direction of the arrangement of the multitude of substrate carriers with respect to the arrangement of treatment stations, layer deposition may be homogenized.

In one embodiment of the apparatus according to the invention, at least one of the first and of the second sputter deposition stations comprises a collimator downstream the respective target. By such collimator a desired microstructure may be induced in the very thin layer which leads to desired magnetic properties.

In one embodiment of the apparatus according to the invention, one of the first and of the second targets is of $Fe_{x1}Co_{y1}$, the arrangement of treatment stations comprising a further sputtering station neighboring suceedingly succeeding the one sputtering station and having a target of Boron. The further sputtering station is controlled by the control unit to be deposition-enabled during the same time as the one sputtering station, and wherein there is valid x1+y1 =100 and 20<y1<50.

In one embodiment of the apparatus according to the invention, one of the first and of the second targets is of Co. The arrangement of treatment stations comprises at least two further sputtering stations, neighboring succeedingly the one sputtering station and having targets of Ta and of Zr respectively. The further sputtering stations are controlled by the control unit to be deposition-enabled during the same time as the one sputtering station.

In one embodiment of the apparatus according to the invention, at least one of the first and of the second targets is of $Fe_{x2}Co_{y2}B_{z2}$, wherein x2+y2+z2 =100.

In one embodiment of the just addressed embodiment the arrangement of treatment stations comprises at least one further layer deposition station configured to deposit a dielectric material layer.

In one embodiment of the apparatus according to the invention, at least one of the first and of the second targets is of $Ni_{x3}Fe_{y3}$, wherein x3+y3=100 and there is valid 50<y3<60 or 17.5<y3<22.5.

In one embodiment of the apparatus according to the invention, the first target is of $Fe_{x4}Co_{y4}$, the second target of $Ni_{x5}Fe_{y5}$ and there is valid x4+y4 =100 and x5+y5=100 and 5<y4<20 and 17.5<y5<22.5 or 50<y5<60.

In one embodiment of the apparatus according to the invention, the first target consists of $Fe_{x6}Co_{y6}B_{z6}$ and the second target consists of $Co_{x7}Ta_{y7}Zr_{z7}$, wherein x6+y6+z6 =100 and x7+y7+z7=100.

In one embodiment of just addressed embodiment there is valid:

$$x6 > y6.$$

In one embodiment of the apparatus according to the invention as just addressed there is valid:

$$y6 \geq z6.$$

In one embodiment of the apparatus according to the invention as just addressed there is valid:

$$x7 > y7.$$

In one embodiment of the apparatus according to the invention as just addressed there is valid:

$$y7 \geq z7.$$

In one embodiment of the apparatus according to the invention as just addressed there is valid at least one or more than one of:

$$45 \leq x6 \leq 60,$$

$$50 \leq x6 \leq 55,$$

$$x6 = 52,$$

$$20 \leq y6 \leq 40,$$

$$25 \leq y6 \leq 30,$$

$$y6 = 28,$$

$$10 \leq z6 \leq 30,$$

$$15 \leq z6 \leq 25,$$

$$z6 = 20.$$

In one embodiment of the apparatus according to the invention as just addressed there is valid at least one or more than one of:

$$85 \leq x7 \leq 95,$$

$$90 \leq x7 \leq 93,$$

$$x7 = 91.5,$$

$$3 \leq y7 \leq 6,$$

$$4 \leq y7 \leq 5,$$

$$y7 = 4.5,$$

$$2 \leq z7 \leq 6,$$

$$3 \leq z7 \leq 5,$$

$$z7 = 4.$$

In one embodiment of the apparatus according to the invention, the control unit is configured to control the relative rotation and/or the power applied to at least the first and the second targets and possibly to further layer deposition stations of the arrangement of treatment stations so as to deposit by each of said first and second sputter deposition stations and possibly at least one further layer deposition station, per substrate exposure thereto, a layer of a respective thickness d for which there is valid at least one of:

$$0.1 \text{ nm} \leq d \leq 3 \text{ nm}$$

$$0.3 \text{ nm} \leq d \leq 2 \text{ nm}$$

$$0.5 \text{ nm} \leq d \leq 1.5 \text{ nm}.$$

Two or more than two embodiments of the apparatus according to the invention and as addressed may be combined unless being in contradiction.

The invention is further directed to a method of manufacturing a substrate with an induction device comprising a core, the core comprising thin layers deposited by sputtering, wherein at least a part of the thin layers are deposited by means of an apparatus according to one of claims 1 to 27.

By the apparatus according to the invention a soft magnetic multilayer stack may be realized comprising first layers of a first soft-magnetic material, second layers of a second soft-magnetic material, the second soft-magnetic material being different from the first soft- magnetic material, the first layers having each a thickness $d_1$, the second layers having each a thickness $d_2$ and wherein there is valid

$$5 \text{ nm} \geq (d_1, d_2) \geq 0.1 \text{ nm}.$$

Thereby the thicknesses $d_1$ and $d_2$ may vary from individual layer to individual layer within the addressed ranges for $d_1$ and $d_2$.

Thereby there may be valid:

$$1 \text{ nm} \geq (d_1, d_2) \geq 0.1 \text{ nm},$$

or at least one of:

$$0.1 \text{ nm} \leq (d_1, d_2) \leq 3 \text{ nm},$$

$$0.3 \text{ nm} \leq (d_1, d_2) \leq 2 \text{ nm},$$

$$0.5 \text{ nm} \leq (d_1, d_2) \leq 1.5 \text{ nm},$$

or

$$0.5 \text{ nm} \geq (d_1, d_2,) \geq 0.1 \text{ nm}$$

or

$$0.5 \text{ nm} \geq (d_1, d_2,) \geq 0.2 \text{ nm.}$$

Thereby the thicknesses $d_1$ and $d_2$ may be equal, e.g. 1 nm.

A At last one of $d_1$ and of $d_2$ may be smaller than 1 nm.

Further the first and the second layers may reside directly one upon the other.

The first layers may be of FeCoB and the second layers of CoTaZr.

The first and second layers may reside directly one upon the other, the stack comprising a multitude of the first and of the second layers, and the multitude may be covered by a layer of non-ferromagnetic material.

The addressed non-ferromagnetic material may be $AlO_2$.

More than one of the addressed multitudes may be provided, with at least one respective layer of the non-ferromagnetic material therebetween.

The soft-magnetic multilayer may comprise:

- A multitude of FeCoB layers,
- A multitude of CoTaZr layers,
- the layers of FeCoB residing in an alternating manner directly on the layers of CoTaZr,

the common multitude of FeCoB layers and of CoTaZr layers being covered by a layer of $AlO_2$.

In the soft magnetic multilayer stack as just addressed, the layers of FeCoB may have a thickness $d_1$ and the layers of CoTaZr may have a thickness $d_2$, $d_1$ and $d_2$ being equal.

In the soft magnetic multilayer stack according to the invention as just addressed there may be valid at least one of:

$$0.1 \text{ nm} \leq (d_1, d_2) \leq 3 \text{ nm,}$$

$$0.3 \text{ nm} \leq (d_1, d_2) \leq 2 \text{ nm,}$$

$$0.5 \text{ nm} \leq (d_1, d_2) \leq 1.5 \text{ nm.}$$

In the soft magnetic multilayer stack as just addressed $d_1$ and $d_2$ may be smaller than 1 nm, down to 0.2 nm.

In spite of the fact the invention becomes clear to the skilled artisan already from the above description, the invention shall now be additionally exemplified with the help of figures. The figures show:

Fig.1: Schematically and simplified an embodiment of the apparatus according to the invention;

Fig.2: Departing from the representation of the apparatus according to Fig.1, the transport chamber and the arrangement of substrate treatment stations of a further embodiment of the apparatus according to the invention;

Fig.3: A sequence of operating steps (a) to (e) as an example of operating the apparatus according to the invention, thereby performing an example of the methods according to the invention;

Fig.4: Schematically and simplified different mechanical conceptions of the arrangement of a multitude of substrate carriers and of the arrangement of substrate treatment stations, according to further embodiments of the apparatus according to the invention.

Fig.5: schematically an example of a further arrangement of treatment stations at an embodiment of the apparatus according to the invention.

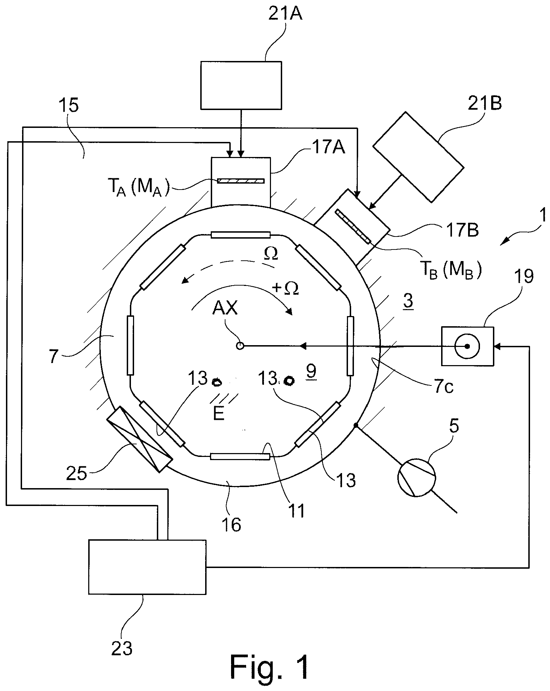

Fig. 1 shows, most schematically and simplified, an embodiment of the soft magnetic material multilayer deposition apparatus according to the invention. The apparatus 1 comprises a vacuum transport chamber 3 which is pumped by a pumping arrangement 5. The vacuum transport chamber 3 has a cylindrical inner space 7, cylindrical about an axis AX. Coaxially with the inner space 7 of the vacuum transport chamber 3 and in the inner space 7, there is provided a rotatably mounted cylindrical transport carrousel 9. Along a plane E, which accords with the drawing plane of Fig. 1 and which is perpendicular to the axis AX, an arrangement 16 of a multitude of substrate carriers 11 is provided, evenly distributed along the periphery of the transport carrousel 9. Each of the substrate carriers 11 is constructed to accommodate and hold a substrate 13 in a position so that one of the extended surfaces $13_o$ of each of the substrates 13 faces, in the embodiment of Fig. 1, the cylindrical surface $7_c$ of the cylindrical inner space 7.

Along the cylindrical surface $7_c$ of the inner space 7, still according to the embodiment of Fig. 1, there is provided an arrangement 15 of substrate treatment stations. In Fig. 1 two of these substrate treatment stations are shown and addressed with the reference signs 17A and 17B. The substrate treatment stations of the addresses arrangement 15 face towards the trajectory path of the substrate carriers 11 so that, being treatment-enabled, they treat the surfaces $13_o$ of the substrates 13.

A rotational drive 19 is operationally coupled to the transport carrousel 9 so as to rotate carrousel 9 about the axis AX. Thereby the arrangement 16 of the multitude of substrate carriers 11, loaded with the substrates 13, passes through the treatment areas of the respective treatment stations of the arrangement 15.

Thus, there is established a relative rotation of the arrangement 16 of the multitude of substrate carriers 11 with respect to the arrangement 15 of treatment stations.

The arrangement 15 of treatment stations comprises or even, in a minimum configuration, consists of a first sputter deposition station 17A and of a second sputter deposition station 17B. The first sputter deposition station 17A has a first sputtering target $T_A$ which consists of a first soft magnetic material to be deposited as a layer material on the substrates 13. This first target material is addressed in Fig. 1 by $M_A$. The material $M_A$ may consist of one or more than one of the ferromagnetic elements Fe,Co,Ni or may comprise, beside of one or more than one of these elements, one or more than one of non-ferromagnetic elements. Such at least one non-ferromagnetic element may be one or more than one element out of the groups IIIA, IVB and VB of the periodic system (according to groups 13,4,5 of IUAPC), thereby especially out of the group B,Ta,Zr.

The second sputter deposition station 17B comprises a second target $T_B$ which consists of a second soft magnetic material $M_B$ which is to be deposited as a layer material on the substrates 13 and which is different from the soft magnetic material $M_A$ of target $T_A$ of the first sputtering station 17A. The material $M_B$ may consist of one or more than one of the ferromagnetic elements Fe,Co,Ni or may comprise, beside of one or more than one of these elements, one or more than one of non-ferromagnetic elements. Such at least one non-ferromagnetic element may be one or more than one element out of the groups IIIA, IVB and VB of the periodic system (according to groups 13,4,5 of IUAPC), thereby especially out of the group B,Ta,Zr.

Thus, at these two sputtering stations 17A and 17B nonreactive sputter deposition is performed and the material to be deposited on the substrates 13 is the solid material of the respective target $T_A$, $T_B$. Thereby, and if $M_A$ and /or $M_B$ are materials of more than one element, the stoichiometry and constancy of the stoichiometry over time of the material deposited on the extended surfaces $13_o$ of the substrate 13 is accurately determined.

The sputtering stations 17A and 17B are electrically supplied by respective supply units 21A and 21B. Depending on the target material $M_A$ and $M_B$ the supply units 21A and 21B are DC-, pulsed DC-, including HIPIMS- supply units or are Rf supply units for single or for multiple frequency electric supply. It is also possible (not shown) to electrically bias the substrate carriers 11 of the arrangement 16 of the multitude of substrate carriers 11, either equally for depositing both materials $M_A$ and $M_B$ or selectively. In the embodiment of Fig.1 this necessitates respective electric connections from biasing sources via the transport carrousel 9 to the substrate carriers 11.

The apparatus 1 further comprises a control unit 23. The control unit 23 on one hand controls the rotational drive 19 and thus relative rotational movement of the transport carrousel 9 and, on the other hand, treatment enablement and disablement of the sputter deposition stations 17A and 17B. Thereby, the control unit 23 is configured to maintain the sputter deposition stations 17A and 17B deposition-enabled, with respect to sputter depositing target material towards the substrate carriers 11 and thus upon the substrates 13 during more than one directly succeeding 360° relative revolutions of the arrangement 16 of the multitude of substrate carriers 11 with respect to the arrangement 15 of treatment stations, about axis AX. The number of revolutions during which the sputter deposition stations 17A and 17B are deposition-enabled, depends on the number of thin layers of the materials $M_A$ and $M_B$ to be deposited as a stack upon the extended surfaces $13_o$ of the substrates 13. The addressed more than one 360° relative revolutions during which the sputter deposition stations 17A and 17B are deposition-enabled, are directly succeeding one another.

E.g., to load and unload substrates 13 to the apparatus, according to the embodiment of Fig.1 to the transport carrousel 9, as schematically shown in Fig. 1 e.g. via a two-directional load-lock arrangement 25, the control unit 23 does additionally control the arrangement 15 of treatment stations including the sputter deposition stations 17A and 17B to selectively disable respective treatment of the substrates 13. This may be realized either by disabling the respective electric supply units, as of 21A and 21B, or by closing and respectively opening a respective shutter (not shown) thereby interrupting substrate treatment by the respective station. This, especially with an eye on the fact that all substrates 13 treated by the apparatus 1 should be equally treated between being loaded to and being unloaded from the apparatus.

[0113] , The control unit controls the rotational drive 19 for a continuous relative rotation at a constant angular velocity with respect to axis AX at least during some of the addressed more than one 360° relative revolutions which directly succeed one another. By such continues constant speed relative rotation, according to Fig.1 of the transport carrousel 9, further transitional states as may be caused by stop and go relative rotation are avoided. Avoiding any hardly controllable transitional states for sputter deposition of the very thin layers by the sputter deposition stations 17A and 17B improves controllability of such deposition. This is also valid for layer deposition on the substrates by possibly provided further layer deposition stations of the arrangement 15 of substrate treatment stations.

As according to the invention, the transport carrousel 9 is controlled via the rotational drive 19 and control unit 23 to relatively rotate at a constant angular relative speed about axis AX at least during some of the more than one 360° uninterrupted relative revolutions, the thickness of each very thin layer deposited especially by the sputter deposition stations 17A and 17B on the surfaces $13_0$ of the substrate 13 becomes governed by the power with which the respective sputtering stations 17A and 17B are supplied by the supply units 21A and 21B, in fact by the respective deposition rate i.e. amount of material deposited per time unit. Thus, the control unit 23 is configured to control the power delivered by the supply units 21A and respectively 21B to the respective sputter deposition stations 17A and 17B, on one hand in dependency from the constant relative rotational speed of the arrangement 16 of the multitude of substrate carriers 11 with respect to the arrangement 15 of treatment stations and, on the other hand, in dependency from the desired very small layer thickness $d_1$ for material $M_A$ and $d_2$ for material $M_B$.

If the arrangement 15 of treatment stations comprises further layer deposition stations which are deposition enabled during the same time as the first and second sputter deposition stations 17A,17B the same prevails: Deposition rate of such further stations is also controlled by the control unit 23 in dependency from the constant relative rotational speed as addressed and, on the other hand, in dependency from the desired very small layer thickness to be deposited by such further layer deposition station.

The thicknesses d including $d_1,d_2$ of the respective materials $M_A$ and $M_B$ and possibly of further materials, which are realized by the apparatus according to the invention and as exemplified in Fig. 1 were addressed above, controlled by control unit 23 for the constant relative rotational speed for multiple 360° revolutions and by respective control, by unit 23, of the supply units as of 21A and 21B of Fig. 1.

As the addressed relative rotation is driven by rotational drive 19 and controlled by control unit 23 for constant relative angular speed rotation, the angular spacing of treatment stations of the arrangement 15 needs not be adapted to the mutual angular spacing of the substrate carriers 11 e.g. along the transport carrousel 9.

As the relative rotation is controlled by the control unit 23 and via rotational drive 19 to be continuous for two or more than two 360° succeeding relative revolutions, homogeneity of the resulting overall stack of very thin layers is improved by inverting the direction of relative revolution e.g. of the transport carrousel 9, as shown in Fig. 1 in dashed lines at -Ω .Such inverting may be controlled by the control unit 23 after a desired number of thin layer having been deposited by the sputter deposition stations 17A and 17B.

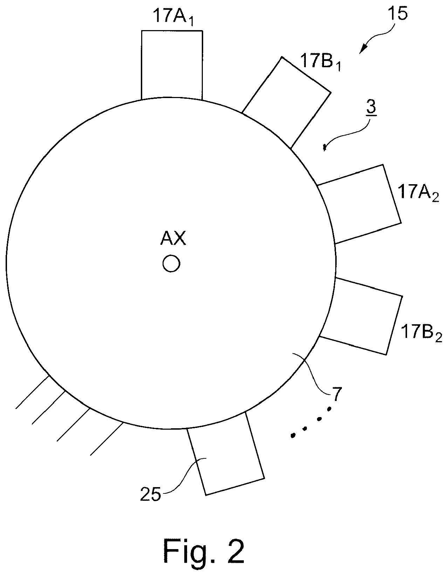

According to Fig. 2 which shows, still simplified and most schematically, the vacuum transport chamber 3, more than one couple of the sputter deposition stations 17A and 17B as of Fig. 1 are provided, represented by $17A_1$, $17A_2$, $17B_1$, $17B_2$ etc. whereby each sputter deposition station $17A_x$ having the respective target of the material $M_A$ and, accordingly, each of the sputter deposition stations $17B_x$ having a target of the material $M_B$ as was addressed also in context with Fig. 1. Nevertheless, more than one first and /or more than one second sputter deposition stations may have respective targets of different soft magnetic material E.g. a station $17_{A1}$ may have a target of soft magnetic material $M_{A1}$, a station $17_{A2}$ a target of a different soft magnetic material $M_{A2}$ etc., and in analogy multiple second sputtering stations $17_{B1}$, $17_{B2}$ etc.

As further shown in Fig. 2, in one embodiment of the apparatus, there is provided, as a part of arrangement 15 of treatment stations, a further layer deposition station 25. This deposition station may not be deposition-activated during the more than one 360° relative revolutions e.g. of the transport carrousel 9. By means of the control unit 23, not anymore shown in Fig. 2, the further layer deposition chamber 25 may only be deposition-activated, as by switching on the respective electrical supply and/or opening a shutter barring deposition upon substrates 13 (not shown in Fig. 2) at selected time spans, after completion of a predetermined number of the addressed continues 360° relative revolutions. By this deposition station 25, in a good embodiment, a thin layer of a dielectric material, as of aluminum oxide, silicon oxide, tantalum oxide, silicon nitride, aluminum nitride and the respective carbides or oxi- carbides or nitro- carbides etc. is deposited, e.g.as a final layer upon the yet finished stack of very thin layers of the materials $M_A$ and $M_B$ and/or as an intermediate dielectric layer after a first predetermined number of very thin layers of $M_A$ and $M_B$ having been deposited and before further depositing a further part of the stack of $M_A$ and $M_B$.

Whereas in the embodiments of Figs. 1 and 2 the sputter deposition stations 17A and 17B are neighboring eachothers, in one embodiment there is provided a further treatment station in between the respective sputter deposition stations 17A and 17B, especially at least one further layer deposition station, especially at least one further sputter deposition chamber. By such further at least one layer deposition station at least one non-ferromagnetic element as one or more than one element out of the groups IIIA, IVB and VB of the periodic system (according to groups 13,4,5 of IUAPC), especially Boron and/or Tantalum and /or Zirconium may be deposited. If such at least one intermediate station is provided, then it might be operated continuously like the sputter deposition stations 17A and 17B or at selected intervals which means only after a predetermined number of very thin layers of the materials $M_A$ and $M_B$ having been deposited on the substrates 13.

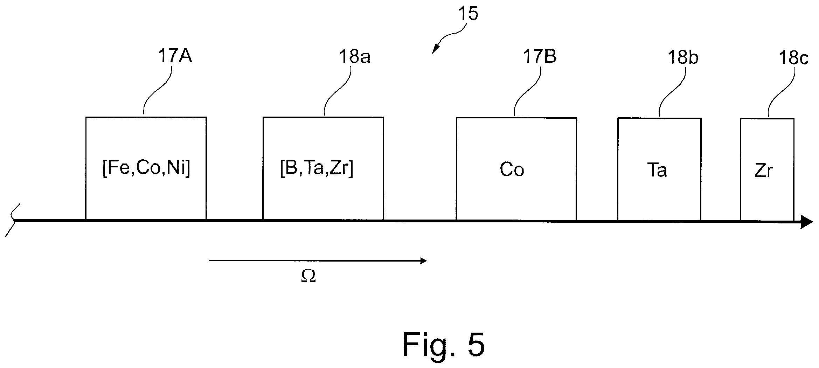

Fig. 5 shows most schematically along the trajectory path of relative rotation $\Omega$ of the arrangement 16 of the multitude of substrate carriers 11 (not shown in Fig.5) with respect to the arrangement 15 of treatment stations an example of stations as arranged along the addressed trajectory path. The first sputter deposition station has a target consisting of at least one of the elements Fe,Ni,Co. A neighboring succeeding further sputter deposition station 18a has a target of at least one of the element B,Ta,Zr.

The second sputter deposition station 17B has a target of Co. Neighboring succeed, further sputter deposition stations 18b and 18c are installed and have, respectively, targets of Ta and Zr.

All the stations 18a to 18c are, as an example, deposition enabled same time as the stations 17A and 17B.

To further improve magnetic characteristics of the very thin layers, collimators (not shown) may be provided between the respective targets $T_A$ and $T_B$ and the revolving substrate carriers 11. Such collimators may also be provided at further layer deposition stations of the arrangement 15 of treatment stations.

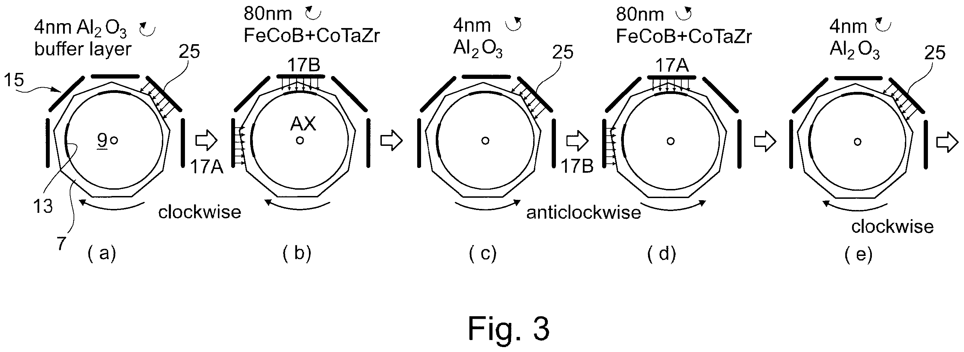

Fig. 3 shows and example of operation of the apparatus e.g. according to the embodiments of Figs. 1 or 2. Therefrom, it might be seen that the cylindrical inner space 7 of the vacuum transport chamber 3 is to be understood also as cylindrically in the sense of approximated by a polygon.

In cycle (a) according to Fig. 3 the layer deposition station 25 is deposition- enabled and all the substrates 13 on the transport carrousel 9 are coated with a buffer layer of aluminum oxide with a thickness of 4 nm. The transport carrousel 9 is clockwise continuously rotated at constant angular speed. Once the buffer layer of aluminum oxide has been deposited on the substrates 13, the deposition station 25, e.g. a Rf sputter deposition chamber operating on an aluminum oxide material target, is deposition-disabled. In the cycle (b) the sputter deposition stations 17A and 17B are enabled for sputter deposition upon the buffer layer on the substrates 13, the transport carrousel 9 still revolving clockwise at constant angular speed. There are deposited, by 40 360° continuous revolutions, 40 couples of material $M_A$ and $M_B$ layers. The material $M_A$ is $Fe_{x6}Co_{y6}B_{z6}$ and the material $M_B$ is $Co_{x7}Ta_{y7}Zr_{z7}$ with values of the stoichiometry factors x6,y6,z6 and x7,y7,z7 as were indicated above.

Specifically, and in one example, the material $M_A$ was $Fe_{52}Co_{28}B_{20}$ and the material $M_B$ was $Co_{91.5}Ta_{4.5}Zr_4$. The sum of thicknesses $d_1$ and $d_2$ was about 2 nm.

There resulted a layer stack of the addressed $M_A$- and $M_B$ very thin layers with a total thickness of about 80 nm. After having deposited this layer stack of about 80 nm thickness, the deposition chamber 25, for aluminum oxide deposition, was deposition- enabled and a thin layer of about 4 nm thickness of aluminum oxide was deposited on the 80 nm layer stack according to cycle (c). Thereby the revolving direction of the transport carrousel 9 was inverted to anticlockwise. Subsequently and according to cycle (d) of Fig. 3, the deposition chamber 25 was again deposition-disabled and the sputter deposition stations 17A and 17B sputter deposition- enabled.

By subsequent 40 360° anticlockwise continuous revolutions of transport carrousel 9 there was again deposited a 80 nm stack of very thin layers of the material $M_A$ and $M_B$.

Thereby it was found, that by reducing $d_1$ as well as $d_2$ of the layers deposited from the addressed $M_A$ and $M_B$ material targets, e.g. from 1 nm down to 0.2 nm, the magnetic property $H_k$ of the stack was improved from 35 Oe to nearly 50 Oe maintaining coercivity extremely low, i.e. smaller than about 0.1 to 0.2 Oe, which is mandatory for soft magnetic multilayers as required by ultra-low loss RF passive devices.

According to cycle (e) and the possibly following further cycles, the cycles (a) to (c) may be repeated as often as desired.

It has to be noted that the stoichiometry parameters and $x_n,y_n,z_n$ may be varied within the ranges as were addressed above to further optimize the soft magnetic behavior of the resulting stack of very thin, soft magnetic material layers for very high frequency applications as of one or several GHZ.

The substrates which were coated in the example according to Fig. 3 were silicon substrates covered with a silicon oxide layer.

Whereas, according to the embodiments of Fig. 1 to 3, the substrate carriers 11 are arranged along the periphery of the transport carrousel 9 in a manner, that substrates supported therein have extended surfaces $13_o$ with normals which radially point outwards with respect to rotational axis AX and towards the respectively positioned stations of the arrangement 15.

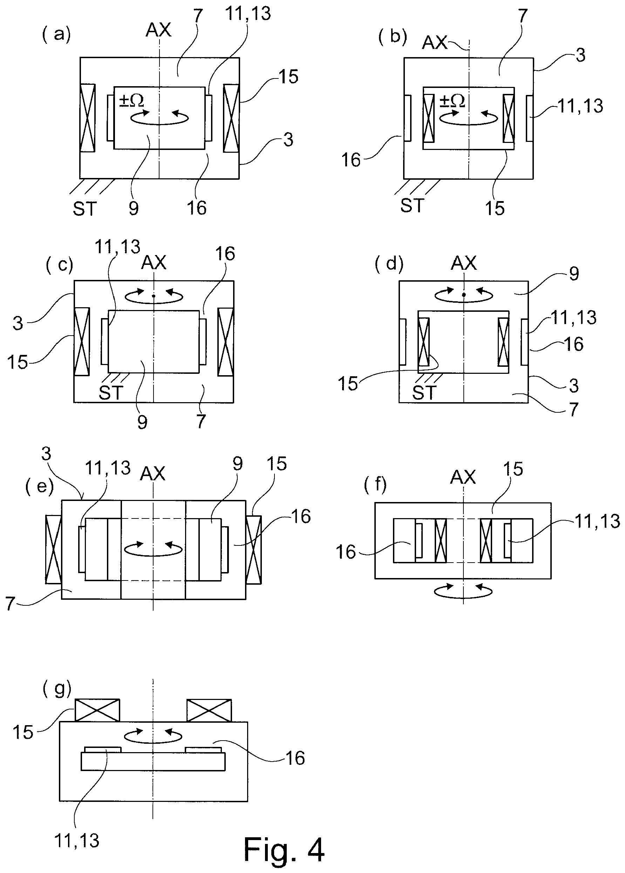

Figs.4(a) to (g) show most schematically various mechanical conceptions of the apparatus according to the invention in which a relative rotation of the arrangement 16 of the multitude of substrate carriers 11 with respect to the arrangement 16 of treatment stations is established.

In the embodiment of Fig.4a the arrangement 15 of treatment stations is stationary. The arrangement 16 of the multitude of substrate carriers 11 with substrates 13 is rotatably and the surfaces to be treated of the substrates 13 face outwards with respect to axis AX, towards the stationary arrangement 15 of treatment stations.

In In the embodiment of Fig.4b the arrangement 16 of the multitude of substrate carriers 11 with the substrates 13 is stationary. The arrangement 15 of treatment stations is rotatable. The surfaces to be treated of the substrates 13 face inwardly with respect to axis AX, towards the rotatable arrangement 15 of treatment stations.

In the embodiment of Fig.4c the arrangement 15 of treatment stations is rotatable. The arrangement 16 of the multitude of substrate carriers 11 with the substrates 13 is stationary and surfaces to be treated of the substrates 13 are directed outwards with respect to the axis AX and face the rotatable arrangement 15 of treatment stations.

In the embodiment of Fig.4d the arrangement 16 of the multitude of substrate carriers 11 with substrates 13 is rotatable. The arrangement 15 of treatment stations is stationary. The surfaces of the substrates 13 to be treated are directed inwards with respect to axis AX and face the stationary arrangement 15 of treatment stations.

Please note that the stationary mount in the figs.4a to 4d is schematically addressed by ST.

In the embodiment of Fig.4e the inner space 7 of vacuum transport chamber 3 is not cylindrical as in the embodiments of Fig.4a to 4d but is annular. The arrangement 15 of treatment stations is stationary or rotatable. The arrangement 16 of the multitude of substrate carriers 11 with the substrates 13 is, respectively, rotatable or stationary. The surfaces to be treated of the substrates 13 are directed outwards with respect to the axis AX a face the arrangement 15 of treatment stations.

In the embodiment of Fig.4f the inner space 7 of the vacuum transport chamber 3 is not cylindrical as in the embodiments of Fig.4a to 4d but is annular. The arrangement 15 of treatment stations is stationary or rotatable. The arrangement 16 of the multitude of substrate carriers 11 with the substrates 13 is respectively rotatable or stationary. The surfaces to be treated of the substrates 13 are directed inwards with respect to the axis AX and face the arrangement 15 of treatment stations.

In the embodiment of Fig.4g the inner space 7 is cylindrical. The arrangement 15 of treatment stations is stationary or rotatable. The arrangement 16 of the multitude of substrate carriers 11 with the substrates 13 is, respectively, rotatable or stationary. The treatment directions of the stations of the arrangement 15 of treatment stations is parallel to the axis AX. The surface to be treated of the substrates 13 are directed parallel to the axis AX and face the arrangement 15 of treatment stations.

As now becomes apparent to the skilled artisan further mechanical combinations of realizing the arrangement 16 of the multitude of substrate carriers 11 for the substrates 13 and of the arrangement 15 of treatment stations are possible, without leaving the scope of the present invention, as defined in the appended claims .

All explanations which were given with respect to the embodiment of the Figs. 1 to 3 and 5 nevertheless prevail also for the embodiments according to Fig. 4.

**Claims**

**1.** A soft magnetic material multilayer deposition apparatus comprising:

- a circular inner space vacuum transport chamber about an axis;
- along a plane perpendicular to said axis, a circular arrangement of a multitude of substrate carriers in said inner space and coaxially to said axis;
- along a plane perpendicular to said axis, a circular arrangement of substrate treatment stations the stations thereof treatment-operative into said inner space;

  - a rotational drive operationally coupled between said circular arrangement of said multitude of substrate carriers and said circular arrangement of treatment stations, so as to establish a relative rotation between said circular arrangement of said multitude of substrate carriers and said circular arrangement of treatment stations;
  - said circular arrangement of said multitude of substrate carriers and said circular arrangement of treatment stations being mutually aligned;

the arrangement of substrate treatment stations comprising:

  - at least one first and at least one second sputter deposition station, each with a single target;
  - the first sputter deposition station having a first target of a first soft magnetic material to be deposited as layer material on the substrates;
  - the second sputter deposition station having a target of a second soft magnetic material, different from said first soft magnetic material and to be deposited as layer material on said substrates;

  **characterized in that** the apparatus further comprising:

  - a control unit operationally coupled to the stations of said arrangement of treatment stations and to said rotational drive and configured to control said first and said second sputter deposition stations so as to be continuously sputter deposition enabled towards the arrangement of the multitude of substrate carriers, during more than one 360° revolution of said arrangement of said multitude of substrate carriers relative to said arrangement of treatment stations and about said axis, said more than one 360° revolutions directly succeeding one another

and wherein
said control unit is further configured to control said rotational drive for continuous relative rotation at a constant angular velocity with respect to said axis for at least some of said more than one 360° revolutions directly succeeding one another.

2. The soft magnetic material multilayer deposition apparatus according to claim 1 said circular inner space being annular and said arrangement of said multitude of substrate carriers or said arrangement of treatment stations being mounted:

- to the radially outer circular surface of said annular inner space, or
- to the top or bottom surface of said annular inner space, or
- to the radially inner circular surface of said annular inner space.

3. The soft magnetic material multilayer deposition apparatus according to claim 1 said circular inner space being cylindrical and said arrangement of said multitude of substrate carriers or said arrangement of treatment stations being mounted to the circular surface being the surrounding surface of said cylindrical inner space or to the bottom surface or to the top surface of said cylindrical inner space.

4. The soft magnetic material multilayer deposition apparatus according to one of claims 1 to 3 wherein said arrangement of treatment stations is stationary.

5. The soft magnetic material multilayer deposition apparatus according to one of claims 1 to 4 wherein said first target comprise or consists of one or more than one element out of the group Fe, Ni, Co and said second target comprises or consists of one or more than one element of the group Fe, Ni, Co.

6. The soft magnetic material multilayer deposition apparatus according to one of claims 1 to 5 wherein said first target consists of one or more than one element of the group Fe, Ni, Co and of at least one non-ferromagnetic element, said at least one non-ferromagnetic element being in particular at least one element out of the groups IIIA, IVB and VB of the periodic system (according to groups 13,4,5 of IUAPC) and further in particular at least one out of the group B, Ta, Zr, and/or said second target consists of one or more than one element out of the group Fe, Ni, Co and of at least one non-ferromagnetic element, said at least one non-ferromagnetic element being in particular at least one element out of the groups IIIA, IVB and VB of the periodic system (according to groups 13,4,5 of IUAPC) and further in particular at least one out of the group B, Ta, Zr.

7. The soft magnetic material multilayer deposition apparatus according to one of claims 1 to 6 wherein said first target comprises or consists of one or more than one element of the group Fe, Ni, Co and said second target comprises or consists of one or more than one element of the group Fe, Ni, Co and further comprising at least one further sputter deposition station neighboring said first and /or said second sputter deposition station and having a target of at least one non-ferromagnetic element, said at least one non-ferromagnetic element being in particular at least one element out of the groups IIIA, IVB and VB of the periodic system (according to groups 13,4,5 of IUAPC) and further in particular at least one out of the group B, Ta, Zr.

8. The soft magnetic material multilayer deposition apparatus according to one of claims 1 to 7, wherein said control unit is configured to control sputtering powers of at least said first and said second sputter deposition stations in dependency of an exposure time each of said substrate carriers is exposed to said first and to said second sputter deposition stations, respectively ,so as to sputter deposit by each of said first and second sputter deposition stations a layer of said first and of said second materials, respectively, of a respectively desired thickness $d_1, d_2$, the desired thicknesses being in particular:

$$10 \ nm \geq (d_1, d_2) \geq 0.1 \ nm;$$

$$5 \text{ nm} \geq (d_1, d_2,) \geq 0.1 \text{ nm};$$

$$1 \text{ nm} \geq (d_1, d_2,) \geq 0.1 \text{ nm};$$

$$0.5 \text{ nm} \geq (d_1, d_2,) \geq 0.1 \text{ nm};$$

or

$$0.5 \text{ nm} \geq (d_1, d_2,) \geq 0.2 \text{ nm}.$$

9. The soft magnetic material multilayer deposition apparatus according to claim 8 being controlled so that the thicknesses $d_1$ and $d_2$ are equal and/or so that $d_1$ and $d_2$ are 1 nm.

10. The soft magnetic material multilayer deposition apparatus according to one of claims 8 or 9 being controlled so that at last one of $d_1$ and $d_2$ is < 1 nm and/or so that the thicknesses $d_1$ and $d_2$ are equal.

11. The soft magnetic material multilayer deposition apparatus according to one of claims 8 to 10 being controlled so that there is valid at least one of

$$0.1 \text{ nm} \leq (d_1, d_2) \leq 3 \text{ nm}$$

$$0.3 \text{ nm} \leq (d_1, d_2) \leq 2 \text{ nm}$$

$$0.5 \text{ nm} \leq (d_1, d_2) \leq 1.5 \text{ nm}.$$

12. The soft magnetic material multilayer deposition apparatus according to one of claims 8 to 10 being controlled so that said first and second layers reside directly one upon the other and/or so that said substrate carriers repeatedly pass said first and said second sputtering stations for a multitude of times.

13. The soft magnetic material multilayer deposition apparatus according to one of claims 8 to 12 wherein said first sputtering station is constructed to deposit FeCoB and said second sputtering station is constructed to deposit CoTaZr.

14. The soft magnetic material multilayer deposition apparatus according to one of claims 1 to 13, said arrangement of treatment stations comprising at least one further layer deposition station, said control unit being configured to control said further layer deposition station so as to continuously deposit at least during said more than one 360° revolutions and said control unit being further configured to control the material deposition rate of said further layer deposition station, in dependency of an exposure time each of said substrate carriers is exposed to said further layer deposition station, so as to deposit by said further layer deposition station a layer of a desired thickness $d_3$, the desired thickness being in particular

$$10 \text{ nm} \geq (d_3) \geq 0.1 \text{ nm},$$

and further in particular

$$5 \text{ nm} \geq d_3 \geq 2 \text{ nm}.$$

15. The soft magnetic material multilayer deposition apparatus of one of claims 1 to 14 comprising more than one of said first sputter deposition stations and/or more than one of said second sputter deposition stations.

16. The soft magnetic material multilayer deposition apparatus of one of claims 1 to 15 wherein said first and said second sputter deposition stations are a pair of mutually neighboring stations along said inner space, the soft magnetic material multilayer deposition apparatus comprising in particular a multitude of said pairs, said first and said second sputter deposition stations being arranged alternatingly.

17. The soft magnetic material multilayer deposition apparatus of one of claims 1 to 16 said first and said second sputter deposition stations being two stations of a group of more than two layer deposition stations, said layer deposition stations of said group being provided along said inner space one neighboring the other and the stations of said group being simultaneously deposition-activated by control of said respectively configured control unit, the soft magnetic material multilayer deposition apparatus comprising in particular more than one of said groups and/or different of said groups.

18. The soft magnetic material multilayer deposition apparatus of one of claims 1 to 17 said arrangement of substrate treatment stations comprising at least one further sputter deposition station configured to sputter deposit a further material towards said substrate holders, said further material being in particular a non-magnetic metal or metal alloy or a dielectric material.

19. The soft magnetic material multilayer deposition apparatus of one of claims 1 to 18 wherein said control unit is configured to controllably enable and disable treatment of said substrates by selected ones or by all of the stations of said arrangement of treatment stations and/or
wherein said control unit is configured to invert direction of relative rotation of said rotational drive.

20. The soft magnetic multilayer deposition apparatus of one of claims 1 to 19 wherein at least one of said first and of said second sputter deposition station comprises a collimator downstream the respective target.

21. The soft magnetic multilayer deposition apparatus of one of claims 1 to 20 wherein one of said first and of said second targets is of $Fe_{x1}Co_{y1}$ , the arrangement of treatment stations comprising a further sputtering station neighboring succeedingly said one sputtering station and having a target of boron said further sputtering station being controlled by said control unit to be deposition-enabled during the same time as said one sputtering station, and wherein there is valid $x1+y1=100$ and $20<y1<50$.

22. The soft magnetic multilayer deposition apparatus of one of claims 1 to 21 wherein one of said first and of said second targets is of Co, the arrangement of treatment stations comprising at least two further sputtering stations, neighboring said one sputtering station and having targets of Ta and of Zr respectively, said further sputtering stations being controlled by said control unit to be deposition-enabled during the same time as said one sputtering station.

23. The soft magnetic multilayer deposition apparatus of one of claims 1 to 22 wherein at least one of said first and of said second targets is of $Fe_{x2}Co_{y2}B_{z2}$, wherein $x2+y2+z2=100$ and wherein particularly the arrangement of treatment stations comprises at least one further layer deposition station configured to deposit a dielectric material layer.

24. The soft magnetic multilayer deposition apparatus of one of claims 1 to 23 wherein at least one of said first and second targets is of $Ni_{x3}Fe_{y3}$, wherein $x3+y3=100$ and there is valid $50<y3<60$ or $17.5<y3<22.5$, and/or wherein said first target is of $Fe_{x4}Co_{y4}$, said second target is of $Ni_{x5}Fe_{y5}$ and there is valid $x4+y4=100$ and $x5+y5=100$ and $5<y4<20$ and $17.5<y5<22.5$ or $50<y5<60$.

25. The soft magnetic multilayer deposition apparatus of one of claims 1 to 24 wherein said first target is of $Fe_{x6}Co_{y6}B_{z6}$ and said second target is of $Co_{x7}Ta_{y7}Zr_{z7}$, wherein $x6+y6+z6=100$ and $x7+y7+z7=100$,
wherein there is in particular valid:

$$x6 > y6;$$

$$y6 \geq z6;$$

$$x7 > y7;$$

and/or

$$y7 \geq z7.$$

26. The soft magnetic multilayer deposition apparatus of claim 25 wherein there is valid at least one or more than one of:

$$45 \leq x6 \leq 60,$$

$$50 \leq x6 \leq 55,$$

$$x6 = 52,$$

$$20 \leq y6 \leq 40,$$

$$25 \leq y6 \leq 30,$$

$$y6 = 28,$$

$$10 \leq z6 \leq 30,$$

$$15 \leq z6 \leq 25,$$

$$z6 = 20$$

and/or
wherein there is valid at least one or more than one of:

$$85 \leq x7 \leq 95,$$

$$90 \leq x7 \leq 93,$$

$$x7 = 91.5,$$

$$3 \leq y7 \leq 6,$$

$$4 \leq y7 \leq 5,$$

$$y7 = 4.5,$$

$$2 \leq z7 \leq 6,$$

$$3 \leq z7 \leq 5,$$

$$z7 = 4.$$

27. The soft magnetic multilayer deposition apparatus of one of claims 1 to 26 wherein said control unit is configured to control said relative rotation and/or power applied to at least said first and said second targets and possibly to further layer deposition stations of said arrangement of treatment stations so as to deposit by each of said first and second sputter deposition stations and possibly at least one further layer deposition station, per substrate exposure thereto, a layer of a respective thickness d for which there is valid at least one of:

$$0.1 \text{ nm} \leq d \leq 3 \text{ nm}$$

$$0.3 \text{ nm} \leq d \leq 2 \text{ nm}$$

$$0.5 \text{ nm} \leq d \leq 1.5 \text{ nm}.$$

28. A method of manufacturing a substrate with an induction device comprising a core, said core comprising thin layers deposited by sputtering, wherein at least a part of said thin layers are deposited by means of an apparatus according to one of claims 1 to 27.

**Patentansprüche**

1. Weichmagnetisch- Material- Mehrschicht- Abscheidungs-Vorrichtung umfassend:

   • eine Vakuumtransportkammer mit einem um eine Achse kreisförmigen Innenraum;
   • entlang einer Ebene senkrecht zu besagter Achse, in besagtem Innenraum eine kreisförmige Anordnung einer Vielzahl von Substratträgern und koaxial zu besagter Achse;
   • entlang einer Ebene senkrecht zu besagter Achse, eine kreisförmige Anordnung von Substrat-Behandlungsstationen, behandlungswirksam in besagten Innenraum;
   • einen Rotationsantrieb, gekoppelt zwischen besagter kreisförmiger Anordnung besagter Vielzahl von Substratträgern und besagter kreisförmigen Anordnung besagter Behandlungsstationen so dass er eine relative Rotation zwischen besagter kreisförmigen Anordnung besagter Vielzahl von Substratträgern und besagter kreisförmigen Anordnung besagter Behandlungsstationen bewirkt;
   • wobei besagte kreisförmige Anordnung besagter Vielzahl von Substratträgern und besagte kreisförmige Anordnung von Behandlungsstationen aufeinander ausgerichtet sind;

   wobei die Anordnung von Substrat-Behandlungsstationen umfasst:

   • mindestens eine erste und mindestens eine zweite Sputter-Abscheidungsstation, jede mit einem einzigen Target;
   • die erste Sputter-Abscheidungsstation mit einem ersten Target aus einem ersten weichmagnetischen Material, welches als Schichtmaterial auf den Substraten abzuscheiden ist;
   • die zweite Sputter-Abscheidungsstation mit einem Target aus einem zweiten, vom ersten weichmagnetischen Material unterschiedlichen weichmagnetischen Material, welches als Schichtmaterial auf den Substraten abzuscheiden ist;
   **dadurch gekennzeichnet, dass** die Vorrichtung ferner umfasst:

   • eine Steuereinheit, die mit den Stationen besagter Anordnung von Behandlungsstationen und mit dem Rotationsantrieb wirkverbunden ist und ausgebildet ist, die erste und die zweite Sputter-Abscheidungsstation so zu steuern, dass eine kontinuierliche Sputter-Abscheidung gegen besagte Anordnung der Vielzahl von Substratträgern während mehr als einer 360°-Umdrehung der Anordnung besagter Vielzahl von Substratträgern relativ zu besagter Anordnung von Behandlungsstationen und um besagte Achse aktiviert ist wobei besagte 360°-Umdrehungen direkt aufeinander folgen,

und wobei
die Steuereinheit ferner ausgebildet ist, den Rotationsantrieb für mindestens einige der aufeinanderfolgenden 360°-Umdrehungen für kontinuierliche relative Rotation bei konstanter Winkelgeschwindigkeit bezüglich besagter Achse zu steuern.

2. Weichmagnetisch- Material- Mehrschicht- Abscheidungs-Vorrichtung nach Anspruch 1, wobei besagter kreisförmige Innenraum ringförmig ist und besagte Anordnung besagter Vielzahl von Substratträgern oder besagte Anordnung von Behandlungsstationen:

   - an der radial äusseren kreisförmigen Oberfläche besagten ringförmigen Innenraums, oder
   - an der oberen oder unteren Fläche des ringförmigen Innenraums, oder
   - an der radial inneren kreisförmigen Oberfläche besagten ringförmigen Innenraums

   angebracht ist.

3. Weichmagnetisch- Material- Mehrschicht- Abscheidungs-Vorrichtung nach Anspruch 1, wobei besagter kreisförmige Innenraum zylindrisch ist und besagte Anordnung besagter Vielzahl von Substratträgern oder besagte Anordnung von Behandlungsstationen an der kreisförmigen Oberfläche, welche die umfassende Oberfläche des zylindrischen Innenraums ist, oder an der unteren Fläche, oder an der oberen Fläche besagten zylindrischen Innenraums angebracht ist.

4. Weichmagnetisch- Material- Mehrschicht- Abscheidungs-Vorrichtung nach einem der Ansprüche 1 bis 3, worin besagte Anordnung von Behandlungsstationen stationär ist.

5. Weichmagnetisch- Material- Mehrschicht- Abscheidungs-Vorrichtung nach einem der Ansprüche 1 bis 4, wobei besagtes erste Target ein oder mehrere der Elemente aus der Gruppe Fe, Ni, Co umfasst oder daraus besteht und besagtes zweite Target ein oder mehrere der Elemente aus der Gruppe Fe, Ni, Co umfasst oder daraus besteht.

6. Weichmagnetisch- Material- Mehrschicht- Abscheidungs-Vorrichtung nach einem der Ansprüche 1 bis 5, wobei das erste Target aus einem oder aus mehreren der Elemente aus der Gruppe Fe, Ni, Co und mindestens einem nicht-ferromagnetischem Element besteht, wobei das mindestens eine nicht-ferromagnetische Element insbesondere mindestens ein Element aus den Gruppen IIIA, IVB und VB des Periodensystems (IUPAC-Gruppen 13,4,5 entsprechend) ist, weiter insbesondere mindestens eines aus der Gruppe B, Ta, Zr,
und/oder
das zweite Target aus einem oder aus mehreren der Elemente aus der Gruppe Fe, Ni, Co und mindestens einem nicht-ferromagnetischen Element besteht, wobei das mindestens eine nicht-ferromagnetische Element insbesondere mindestens ein Element aus den Gruppen IIIA, IVB und VB des Periodensystems (IUPAC-Gruppen 13,4,5 entsprechend) ist, weiter insbesondere mindestens eines aus der Gruppe B, Ta, Zr.

7. Weichmagnetisch- Material- Mehrschicht- Abscheidungs-Vorrichtung nach einem der Ansprüche 1 bis 6, wobei das erste Target ein oder mehrere Elemente aus der Gruppe Fe, Ni, Co umfasst oder daraus besteht und das zweite Target ein oder mehrere Elemente aus der Gruppe Fe, Ni, Co umfasst oder daraus besteht, und weiter umfassend mindestens eine weitere, zu der ersten und/oder zweiten Sputter-Abscheidungsstation benachbarte Sputter-Abscheidungsstation mit einem Target aus mindestens einem nicht-ferromagnetischen Element, wobei das mindestens eine nicht-ferromagnetische Element insbesondere mindestens ein Element aus den Gruppen IIIA, IVB und VB des Periodensystems (IUPAC-Gruppen 13,4,5 entsprechend) ist und weiter insbesondere mindestens eines aus der Gruppe B, Ta, Zr.

8. Weichmagnetisch- Material- Mehrschicht- Abscheidungs-Vorrichtung nach einem der Ansprüche 1 bis 7, wobei die Steuereinheit ausgebildet ist, die Sputter-Leistungen mindestens der ersten und der zweiten Sputter-Abscheidungsstation in Abhängigkeit von einer Expositionszeit, mit der jeder der Substratträger der ersten und der zweiten Sputter-Abscheidungsstation jeweils ausgesetzt ist, so zu steuern, dass durch jede besagter ersten und besagter zweiten Sputter-Abscheidungsstationen eine Schicht aus dem ersten und aus dem zweiten Material mit einer jeweils gewünschten Dicke $d_1, d_2$ abgeschieden wird, wobei die gewünschten Dicken insbesondere betragen:

$$10 \ \text{nm} \ \geq \ (d_1, d_2) \ \geq \ 0.1 \ \text{nm};$$

$$5 \ \text{nm} \ \geq \ (d_1, d_2,) \ \geq \ 0.1 \ \text{nm};$$

$$1 \ \text{nm} \ \geq \ (d_1, d_2,) \ \geq \ 0.1 \ \text{nm};$$

$$0.5 \ \text{nm} \ \geq \ (d_1, d_2,) \ \geq \ 0.1 \ \text{nm};$$

oder

$$0.5 \ \text{nm} \ \geq \ (d_1, d_2,) \ \geq \ 0.2 \ \text{nm}.$$

9. Weichmagnetisch- Material- Mehrschicht- Abscheidungs-Vorrichtung nach Anspruch 8, so gesteuert, dass die Dicken $d_1$ und $d_2$ gleich sind und/oder dass $d_1$ und $d_2$ 1 nm sind.

10. Weichmagnetisch- Material- Mehrschicht- Abscheidungs-Vorrichtung nach einem der Ansprüche 8 oder 9, so gesteuert, dass mindestens eine von $d_1$ und $d_2$ < 1 nm ist und/oder dass die Dicken $d_1$ und $d_2$ gleich sind.

11. Weichmagnetisch- Material- Mehrschicht- Abscheidungs-Vorrichtung nach einem der Ansprüche 8 bis 10, so gesteuert, dass mindestens eines gilt:

$$0.1 \ \text{nm} \ \leq \ (d_1, d_2) \ \leq \ 3 \ \text{nm}$$

$$0.3 \ \text{nm} \ \leq \ (d_1, d_2) \ \leq \ 2 \ \text{nm}$$

$$0.5 \ \text{nm} \ \leq \ (d_1, d_2) \ \leq \ 1.5 \ \text{nm}.$$

12. Weichmagnetisch- Material- Mehrschicht- Abscheidungs-Vorrichtung nach einem der Ansprüche 8 bis 10, so gesteuert, dass besagte erste und besagte zweite Schicht direkt aufeinander liegen und/oder dass besagte Substratträger besagte erste und besagte zweite Sputter-Stationen wiederholt mehrfach passieren.

13. Weichmagnetisch- Material- Mehrschicht- Abscheidungs-Vorrichtung nach einem der Ansprüche 8 bis 12, wobei besagte erste Sputter-Station zur Abscheidung von FeCoB ausgelegt ist und besagte zweite Sputter-Station zur Abscheidung von CoTaZr.

14. Weichmagnetisch- Material- Mehrschicht- Abscheidungs-Vorrichtung nach einem der Ansprüche 1 bis 13, wobei besagte Anordnung von Behandlungsstationen mindestens eine weitere Schichtabscheidungsstation umfasst, die Steuereinheit so zur Steuerung der weiteren Schichtabscheidungsstation ausgebildet ist, dass sie zumindest während der mehr als einen 360°-Umdrehung kontinuierlich abscheidet, und wobei die Steuereinheit ferner ausgebildet ist, die Materialabscheidungsrate der weiteren Schichtabscheidungsstation in Abhängigkeit von einer Expositionszeit, mit der jeder besagter Substratträger der weiteren Schichtabscheidungsstation ausgesetzt ist, so zu steuern, dass eine Schicht mit einer gewünschten Dicke $d_3$ durch die weitere Schichtabscheidungsstation abgeschieden wird, wobei die gewünschte Dicke insbesondere

$$10 \ \text{nm} \ \geq \ (d_3) \ \geq \ 0.1 \ \text{nm},$$

und weiter insbesondere

$$5 \text{ nm} \geq d_3 \geq 2 \text{ nm ist.}$$

15. Weichmagnetisch- Material- Mehrschicht- Abscheidungs-Vorrichtung nach einem der Ansprüche 1 bis 14 umfassend mehr als eine besagter ersten Sputter-Abscheidungsstationen und/oder mehr als eine besagter zweiten Sputter-Abscheidungsstationen.

16. Weichmagnetisch- Material- Mehrschicht- Abscheidungs-Vorrichtung nach einem der Ansprüche 1 bis 15, wobei besagte erste und besagte zweite Sputter-Abscheidungsstation ein Paar entlang besagten Innenraums benachbarter Stationen sind, die Weichmagnetisch- Material- Mehrschicht- Abscheidungs-Vorrichtung insbesondere eine Vielzahl besagter Paare umfasst, wobei besagte erste und besagte zweite Sputter-Abscheidungsstationen abwechselnd angeordnet sind.

17. Weichmagnetisch- Material- Mehrschicht- Abscheidungs-Vorrichtung nach einem der Ansprüche 1 bis 16, wobei besagte erste und besagte zweite Sputter-Abscheidungsstation zwei Stationen einer Gruppe von mehr als zwei Schichtabscheidungsstationen sind, wobei die Schichtabscheidungsstationen besagter Gruppe sich benachbarend entlang besagten Innenraums angeordnet sind und die Stationen besagter Gruppe durch Steuerung der entsprechend ausgebildeten Steuereinheit gleichzeitig zur Abscheidung aktiviert sind, wobei die Weichmagnetisch- Material- Mehrschicht- Abscheidungs- Vorrichtung insbesondere mehr als eine besagter Gruppen und/oder unterschiedliche besagter Gruppen umfasst.

18. Weichmagnetisch- Material- Mehrschicht- Abscheidungs-Vorrichtung nach einem der Ansprüche 1 bis 17, wobei besagte Anordnung von Substrat-Behandlungsstationen mindestens eine weitere Sputter-Abscheidungsstation umfasst, die zur Abscheidung eines weiteren Materials gegen besagte Substrathalter mittels Sputterns ausgebildet ist, wobei das weitere Material insbesondere ein nicht-magnetisches Metall oder -Metalllegierung oder ein dielektrisches Material ist.

19. Weichmagnetisch- Material- Mehrschicht- Abscheidungs-Vorrichtung nach einem der Ansprüche 1 bis 18, wobei besagte Steuereinheit ausgebildet ist, das Behandeln der Substrate durch gewählte oder durch alle Stationen besagter Anordnung von Behandlungsstationen gesteuert zu aktivieren und zu deaktivieren
und/oder
wobei besagte Steuereinheit zur Richtungsumkehr der relativen Rotation des Rotationsantriebs ausgebildet ist.

20. Weichmagnetisch- Material- Mehrschicht- Abscheidungs-Vorrichtung nach einem der Ansprüche 1 bis 19, wobei mindestens eine besagter ersten und besagter zweiten Sputter-Abscheidungsstation einen Kollimator stromabwärts des jeweiligen Targets umfasst.

21. Weichmagnetisch- Material- Mehrschicht- Abscheidungs-Vorrichtung nach einem der Ansprüche 1 bis 20, wobei eines besagten ersten und besagten zweiten Targets $Fe_{X_1}Co_{y_1}$ ist, wobei die Anordnung von Behandlungsstationen eine weitere Sputter-Station umfasst, die der einen Sputter-Station benachbart folgt und ein Bor-Target hat, wobei die weitere Sputter-Station von der Steuereinheit so gesteuert wird, dass sie während der gleichen Zeit wie die eine Sputter-Station für das Abscheiden aktiviert ist, und wobei x1+y1=100 und 20<y1<50 gilt.

22. Weichmagnetisch- Material- Mehrschicht- Abscheidungs-Vorrichtung nach einem der Ansprüche 1 bis 21, wobei eines besagten ersten und besagten zweiten Targets Co ist, wobei die Anordnung von Behandlungsstationen mindestens zwei weitere Sputter-Stationen umfasst, die zu der einen Sputter-Station benachbart sind und Targets aus Ta bzw. Zr haben, wobei besagte weiteren Sputter-Stationen von der Steuereinheit so gesteuert werden, dass sie während gleicher Zeit wie besagte eine Sputter-Station Abscheidungs-aktiviert sind.

23. Weichmagnetisch- Material- Mehrschicht- Abscheidungs-Vorrichtung nach einem der Ansprüche 1 bis 22, wobei mindestens eines besagten ersten und besagten zweiten Targets $Fe_{x_2}Co_{y_2}B_{z_2}$ ist, wobei x2+y2+z2=100 und wobei insbesondere die Anordnung von Behandlungsstationen mindestens eine weitere Schichtabscheidungsstation umfasst, die zum Abscheiden einer Schicht aus dielektrischem Material ausgebildet ist.

24. Weichmagnetisch- Material- Mehrschicht- Abscheidungs-Vorrichtung nach einem der Ansprüche 1 bis 23, wobei mindestens eines besagten ersten und besagten zweiten Targets $Ni_{x_3}Fe_{y_3}$ ist, wobei x3+y3=100 und 50<y3<60 oder 17.5<y3<22.5 gilt, und/oder wobei das erste Target $Fe_{x_4}Co_{y_4}$ ist, das zweite Target $Ni_{x_5}Fe_{y_5}$ und x4+y4=100 und x5+y5=100 und 5<y4<20 und 17.5<y5<22.5 oder 50<y5<60 gilt.

25. Weichmagnetisch- Material- Mehrschicht- Abscheidungs-Vorrichtung nach einem der Ansprüche 1 bis 24, wobei das erste Target $Fe_{x6}Co_{y6}B_{z6}$ ist und das zweite $Co_{x7}Ta_{y7}Zr_{z7}$, wobei x6+y6+z6=100 und x7+y7+z7=100, wobei insbesondere gilt:

$$x6 > y6;$$

$$y6 \geq z6;$$

$$x7 > y7;$$

und/oder

$$y7 \geq z7.$$

26. Weichmagnetisch- Material- Mehrschicht- Abscheidungs-Vorrichtung nach Anspruch 25, wobei mindestens eines oder mehreres des Folgenden gilt:

$$45 \leq x6 \leq 60,$$

$$50 \leq x6 \leq 55,$$

$$x6 = 52,$$

$$20 \leq y6 \leq 40,$$

$$25 \leq y6 \leq 30,$$

$$y6 = 28,$$

$$10 \leq z6 \leq 30,$$

$$15 \leq z6 \leq 25,$$

$$z6 = 20 \text{ gilt}$$

und/oder wobei mindestens eines oder mehreres des Folgenden gilt:

$$85 \leq x7 \leq 95,$$

$$90 \leq x7 \leq 93,$$

$$x7 = 91.5,$$

$$3 \leq y7 \leq 6,$$

$$4 \leq y7 \leq 5,$$

$$y7 = 4.5,$$

$$2 \leq z7 \leq 6,$$

$$3 \leq z7 \leq 5,$$

$$z7 = 4.$$

27. Weichmagnetisch- Material- Mehrschicht- Abscheidungs-Vorrichtung nach einem der Ansprüche 1 bis 26, wobei besagte Steuereinheit ausgebildet ist, die relative Rotation und/oder die Leistung, die zumindest dem ersten und dem zweiten Target und möglicherweise weiterer Schichtabscheidungsstationen besagter Anordnung von Behandlungsstationen zugeführt wird, so zu steuern , dass durch jede besagter ersten und zweiten Sputter-Abscheidungsstationen und möglicherweise mindestens einer weiteren Schichtabscheidungsstation, eine Schicht mit einer entsprechenden Dicke d pro Substratexposition abgeschieden wird, wobei mindestens eines des Folgenden gilt:

$$0.1 \text{ nm} \leq d \leq 3 \text{ nm}$$

$$0.3 \text{ nm} \leq d \leq 2 \text{ nm}$$

$$0.5 \text{ nm} \leq d \leq 1.5 \text{ nm}.$$

28. Verfahren zur Herstellung eines Substrats mit einer Induktionsvorrichtung umfassend einen Kern, wobei der Kern dünne, mittels Sputterns abgeschiedene Schichten umfasst, wobei mindestens ein Teil der dünnen Schichten mittels einer Vorrichtung nach einem der Ansprüche 1 bis 27 abgeschieden wird.

**Revendications**

1. Appareil de dépôt multicouches de matériau magnétique doux comprenant :

   - une chambre de transport sous vide d'espace intérieur circulaire autour d'un axe ;
   - le long d'un plan perpendiculaire audit axe, un agencement circulaire d'une multitude de supports de substrat dans ledit espace intérieur et de façon coaxiale par rapport audit axe ;
   - le long d'un plan perpendiculaire audit axe, un agencement circulaire de stations de traitement de substrat, les stations de traitement opérant dans ledit espace intérieur ;
   - un entraînement en rotation couplé de façon opérationnelle entre ledit agencement circulaire de ladite multitude de supports de substrat et ledit agencement circulaire de stations de traitement de façon à créer une rotation relative entre ledit agencement circulaire de ladite multitude de supports de substrat et ledit agencement circulaire de stations de traitement ;
   - ledit agencement circulaire de ladite multitude de supports de substrat et ledit agencement circulaire de stations de traitement étant alignés l'un par rapport à l'autre ;
   l'agencement de stations de traitement de substrat comprenant :

      - au moins une première et au moins une deuxième station de dépôt par pulvérisation, chacune avec une seule cible ;

- la première station de dépôt par pulvérisation ayant une première cible d'un premier matériau magnétique doux à déposer comme matériau de couche sur les substrats ;
- la deuxième station de dépôt par pulvérisation ayant une cible d'un deuxième matériau magnétique doux, différent dudit premier matériau magnétique doux, à déposer comme matériau de couche sur lesdits substrats ;

**caractérisé en ce que** l'appareil comprend en outre :

- une unité de commande raccordée de façon opérationnelle aux stations dudit agencement de stations de traitement et audit entraînement en rotation et conçue pour commander ladite première et ladite deuxième stations de dépôt par pulvérisation de façon à ce que le dépôt par pulvérisation soit activé en continu vers l'agencement de la multitude de supports de substrat pendant plus d'un tour à 360° dudit agencement de ladite multitude de supports de substrat par rapport audit agencement de stations de traitement et autour dudit axe, lesdits plus d'un tours à 360° se succédant directement les uns après les autres,

et dans lequel
ladite unité de commande est en outre conçue pour commander ledit entraînement en rotation pour que la rotation relative soit continue à une vitesse angulaire constante par rapport audit axe pendant au moins quelques-uns desdits plus d'un tours à 360° successifs.

2. Appareil de dépôt multicouches de matériau magnétique doux selon la revendication 1, ledit espace intérieur circulaire étant annulaire et ledit agencement de ladite multitude de supports de substrat ou ledit agencement de stations de traitement étant monté :

- sur la surface circulaire radialement extérieure dudit espace intérieur annulaire, ou
- sur la surface supérieure ou inférieure dudit espace intérieur annulaire, ou
- sur la surface circulaire radialement intérieure dudit espace intérieur annulaire.

3. Appareil de dépôt multicouches de matériau magnétique doux selon la revendication 1, ledit espace intérieur circulaire étant cylindrique et ledit agencement de ladite multitude de supports de substrat ou ledit agencement de stations de traitement étant monté sur la surface circulaire étant la surface environnante dudit espace intérieur cylindrique ou sur la surface inférieure ou sur la surface supérieure dudit espace intérieur cylindrique.

4. Appareil de dépôt multicouches de matériau magnétique doux selon l'une des revendications 1 à 3, dans lequel ledit agencement de stations de traitement est stationnaire.

5. Appareil de dépôt multicouches de matériau magnétique doux selon l'une des revendications 1 à 4, dans lequel ladite première cible comprend ou est composée d'un ou plus d'un élément du groupe Fe, Ni, Co, et dans lequel ladite deuxième cible comprend ou est composée d'un ou plus d'un élément du groupe Fe, Ni, Co.

6. Appareil de dépôt multicouches de matériau magnétique doux selon l'une des revendications 1 à 5, dans lequel ladite première cible est composée d'un ou plus d'un élément du groupe Fe, Ni, Co et d'au moins un élément non ferromagnétique, ledit au moins un élément non ferromagnétique étant en particulier au moins un élément des groupes IIIA, IVB et VB du système périodique (selon les groupes 13, 4, 5 d'UICPA), et plus particulièrement au moins un du groupe B, Ta, Zr, et/ou dans lequel ladite deuxième cible est composée d'un ou plus d'un élément du groupe Fe, Ni, Co et d'au moins un élément non ferromagnétique, ledit au moins un élément non ferromagnétique étant en particulier au moins un élément des groupes IIIA, IVB et VB du système périodique (selon les groupes 13, 4, 5 d'UICPA) et plus particulièrement au moins un du groupe B, Ta, Zr.

7. Appareil de dépôt multicouches de matériau magnétique doux selon l'une des revendications 1 à 6, dans lequel ladite première cible comprend ou est composée d'un ou plus d'un élément du groupe Fe, Ni, Co, et dans lequel ladite deuxième cible comprend ou est composée d'un ou plus d'un éléments du groupe Fe, Ni, Co et comprenant en outre au moins une autre station de dépôt par pulvérisation adjacente à ladite première et/ou à ladite deuxième station de dépôt par pulvérisation et ayant une cible d'au moins un élément non ferromagnétique, ledit au moins un élément non ferromagnétique étant en particulier au moins un élément des groupes IIIA, IVB et VB du système périodique (selon les groupes 13, 4, 5 d'UICPA), et plus particulièrement au moins un du groupe B, Ta, Zr.

8. Appareil de dépôt multicouches de matériau magnétique doux selon l'une des revendications 1 à 7, dans lequel ladite unité de commande est conçue pour commander les puissances de pulvérisation d'au moins lesdites première et deuxième stations de dépôt par pulvérisation en fonction d'un temps d'exposition, chacun desdits supports de substrat étant respectivement exposé auxdites première et deuxième stations de dépôt par pulvérisation, de façon à ce que chacune desdites première et deuxième stations de dépôt par pulvérisation dépose respectivement par pulvérisation une couche desdits premier et deuxième matériaux d'une épaisseur $d_1$, $d_2$ respectivement souhaitée, l'épaisseur souhaitée étant en particulier :

$$10 \text{ nm} \geq (d_1, d_2) \geq 0.1 \text{ nm} ;$$

$$5 \text{ nm} \geq (d_1, d_{2,}) \geq 0.1 \text{ nm} ;$$

$$1 \text{ nm} \geq (d_1, d_{2,}) \geq 0.1 \text{ nm} ;$$

$$0.5 \text{ nm} \geq (d_1, d_{2,}) \geq 0.1 \text{ nm} ;$$

ou

$$0.5 \text{ nm} \geq (d_1, d_{2,}) \geq 0.2 \text{ nm}.$$

9. Appareil de dépôt multicouches de matériau magnétique doux selon la revendication 8, l'appareil étant commandé de sorte que les épaisseurs $d_1$ et $d_2$ soient égales et/ou de sorte que $d_1$ et $d_2$ soient de 1 nm.

10. Appareil de dépôt multicouches de matériau magnétique doux selon l'une des revendications 8 ou 9, l'appareil étant commandé de sorte qu'au moins l'une des épaisseurs $d_1$ et $d_2$ soit < 1 nm et/ou de sorte que les épaisseurs $d_1$ et $d_2$ soient égales.

11. Appareil de dépôt multicouches de matériau magnétique doux selon l'une des revendications 8 à 10, l'appareil étant commandé de sorte qu'au moins une des conditions suivantes soit valide

$$0.1 \text{ nm} \leq (d_1, d_2) \leq 3 \text{ nm}$$

$$0.3 \text{ nm} \leq (d_1, d_2) \leq 2 \text{ nm}$$

$$0.5 \text{ nm} \leq (d_1, d_2) \leq 1.5 \text{ nm}.$$

12. Appareil de dépôt multicouches de matériau magnétique doux selon l'une des revendications 8 à 10, l'appareil étant commandé de sorte que lesdites première et deuxième couches soient directement l'une sur l'autre et/ou de sorte que lesdits supports de substrat passent à plusieurs reprises lesdites première et deuxième stations de pulvérisation pour une multitude de fois.

13. Appareil de dépôt multicouches de matériau magnétique doux selon l'une des revendications 8 à 12, dans lequel ladite première station de pulvérisation est conçue pour déposer du FeCoB et ladite deuxième station de pulvérisation est conçue pour déposer du CoTaZr.

14. Appareil de dépôt multicouches de matériau magnétique doux selon l'une des revendications 1 à 13, ledit agencement de stations de traitement comprenant au moins une autre station de dépôt de couche, ladite unité de commande étant conçue pour commander ladite autre station de dépôt de couche de façon à déposer en continu au moins pendant lesdits plus d'un tours à 360°, et ladite unité de commande étant en outre conçue pour commander la vitesse de dépôt de matériau de ladite autre station de dépôt de couche, selon le temps d'exposition chacun desdits supports de substrat étant exposé à ladite autre station de dépôt de couche de façon à déposer, par le biais de ladite autre station de dépôt de couche, une couche d'une épaisseur $d_3$ souhaitée, l'épaisseur souhaitée étant en particulier

$$10 \text{ nm} \geq (d_3) \geq 0.1 \text{ nm},$$

et plus particulièrement

$$5 \text{ nm} \geq d_3 \geq 2 \text{ nm}.$$

15. Appareil de dépôt multicouches de matériau magnétique doux selon l'une des revendications 1 à 14 comprenant plus d'un desdites premières stations de dépôt par pulvérisation et/ou plus d'un desdites deuxièmes stations de dépôt par pulvérisation.

16. Appareil de dépôt multicouches de matériau magnétique doux selon l'une des revendications 1 à 15, dans lequel ladite première et ladite deuxième stations de dépôt par pulvérisation sont une paire de stations mutuellement adjacentes le long dudit espace intérieur, l'appareil de dépôt multicouches de matériau magnétique doux comprenant en particulier une multitude desdites paires, lesdites premières et lesdites deuxièmes stations de dépôt par pulvérisation étant disposées en alternance.

17. Appareil de dépôt multicouches de matériau magnétique doux selon l'une des revendications 1 à 16, ladite première et ladite deuxième stations de dépôt par pulvérisation étant deux stations d'un groupe de plus de deux stations de dépôt de couche, lesdites stations de dépôt de couche dudit groupe étant prévus le long dudit espace intérieur l'une voisine de l'autre, et les stations dudit groupe étant dépôt-activés simultanément en commandant ladite unité de commande respectivement configurée, l'appareil de dépôt multicouches de matériau magnétique doux comprenant en particulier plus d'un desdits groupes et/ou différents desdites groupes.

18. Appareil de dépôt multicouches de matériau magnétique doux selon l'une des revendications 1 à 17, ledit agencement de stations de traitement de substrat comprenant au moins une autre station de dépôt par pulvérisation conçue pour déposer par pulvérisation un autre matériau vers lesdits supports de substrat, ledit autre matériau étant en particulier un métal non magnétique ou un alliage métallique ou un matériau diélectrique.

19. Appareil de dépôt multicouches de matériau magnétique doux selon l'une des revendications 1 à 18, dans lequel ladite unité de commande est conçue pour activer et désactiver de manière contrôlable le traitement desdits substrats en sélectionnant quelques-unes ou la totalité des stations dudit agencement de stations de traitement, et/ou dans lequel ladite unité de commande est conçue pour inverser le sens de rotation relative dudit entraînement en rotation.

20. Appareil de dépôt multicouches de matériau magnétique doux selon l'une des revendications 1 à 19, dans lequel au moins l'une desdites première et deuxième stations de dépôt par pulvérisation comprend un collimateur en aval de la cible respective.

21. Appareil de dépôt multicouches de matériau magnétique doux selon l'une des revendications 1 à 20, dans lequel l'une desdites première et deuxième cibles est du $Fe_{x1}Co_{y1}$, l'agencement de stations de traitement comprenant une autre station de pulvérisation adjacente à ladite une station de pulvérisation et ayant une cible de bore, ladite autre station de pulvérisation étant commandée par ladite unité de commande pour être dépôt-activée pendant la même durée que ladite une station de pulvérisation, et dans lequel $x1 + y1 = 100$ et $20 < y1 < 50$ est valide.

22. Appareil de dépôt multicouches de matériau magnétique doux selon l'une des revendications 1 à 21, dans lequel l'une desdites première et deuxième cibles est constituée de Co, l'agencement de stations de traitement comprenant au moins deux autres stations de pulvérisation, voisines à ladite une station de pulvérisation et ayant des cibles de Ta et de Zr respectivement, lesdites autres stations de pulvérisation étant commandées par ladite unité de commande pour être dépôt-activées pendant la même durée que ladite une station de pulvérisation.

23. Appareil de dépôt multicouches de matériau magnétique doux selon l'une des revendications 1 à 22, dans lequel au moins l'une desdites première et deuxième cibles est constituée de $Fe_{x2}Co_{y2}B_{z2}$, dans lequel $x2 + y2 + z2 = 100$, et dans lequel en particulier l'agencement de stations de traitement comprend au moins une autre station de dépôt de couche conçue pour déposer une couche de matériau diélectrique.

24. Appareil de dépôt multicouches de matériau magnétique doux selon l'une des revendications 1 à 23, dans lequel au moins l'une desdites première et deuxième cibles est constituée de $Ni_{x3}Fe_{y3}$, dans lequel x3 + y3 = 100 et dans lequel 50 < y3 < 60 ou 17.5 < y3 < 22.5 est valide, et/ou dans lequel ladite première cible est constituée de $Fe_{x4}Co_{y4}$, ladite deuxième cible est constituée de $Ni_{x5}Fe_{y5}$ et x4 + y4 = 100 et x5 + y5 = 100 et 5 < y4 < 20 et 17.5<y5<22.5 ou 50 < y5 < 60 est valide.

25. Appareil de dépôt multicouches de matériau magnétique doux selon l'une des revendications 1 à 24, dans lequel ladite première cible est constituée de $Fe_{x6}Co_{y6}B_{z6}$ et ladite deuxième cible est constituée de $Co_{x7}Ta_{y7}Zr_{z7}$, dans lequel x6 + y6 + z6 = 100 et x7 + y7 + z7 = 100, et dans lequel en particulier est valide :

$$x6 > y6 \; ;$$

$$y6 \geq z6 \; ;$$

$$x7 > y7 \; ;$$

et/ou

$$y7 \geq z7 .$$

26. Appareil de dépôt multicouches de matériau magnétique doux selon la revendication 25, dans lequel au moins une ou plus d'un des conditions suivantes est valide :

$$45 \leq x6 \leq 60,$$

$$50 \leq x6 \leq 55,$$

$$x6 = 52,$$

$$20 \leq y6 \leq 40,$$

$$25 \leq y6 \leq 30,$$

$$y6 = 28,$$

$$10 \leq z6 \leq 30,$$

$$15 \leq z6 \leq 25,$$

$$z6 = 20$$

et/ou dans lequel au moins une ou plus d'un des conditions suivantes est valide:

$$85 \leq x7 \leq 95,$$

$$90 \leq x7 \leq 93,$$

$$x7 = 91.5,$$

$$3 \leq y7 \leq 6,$$

$$4 \leq y7 \leq 5,$$

$$y7 = 4.5,$$

$$2 \leq z7 \leq 6,$$

$$3 \leq z7 \leq 5,$$

$$z7 = 4.$$

27. Appareil de dépôt multicouches de matériau magnétique doux selon l'une des revendications 1 à 26, dans lequel ladite unité de commande est conçue pour commander ladite rotation relative et/ou la puissance appliquée au moins auxdites première et deuxième cibles et éventuellement aux autres stations de dépôt de couche dudit agencement de stations de traitement de façon à ce que chacune desdites première et deuxième stations de dépôt par pulvérisation et éventuellement au moins une autre station de dépôt de couche, par exposition de substrat à ces dernières, déposent une couche d'une épaisseur d respective pour laquelle au moins l'une des conditions suivantes est valide:

$$0.1 \text{ nm} \leq d \leq 3 \text{ nm}$$

$$0.3 \text{ nm} \leq d \leq 2 \text{ nm}$$

$$0.5 \text{ nm} \leq d \leq 1.5 \text{ nm}.$$

28. Procédé de fabriquer un substrat avec un dispositif d'induction comprenant un noyau, ledit noyau comprenant de fines couches déposées par pulvérisation, dans lequel au moins une partie desdites fines couches sont déposées au moyen d'un appareil selon l'une des revendications 1 à 27.

Fig. 1

$17A_1$

15

$17B_1$

3

$17A_2$

AX

○

$17B_2$

7

25

· · · ·

# Fig. 2

Fig. 3

EP 3 616 222 B1

Fig. 4

EP 3 616 222 B1

Fig. 5

**EP 3 616 222 B1**

## REFERENCES CITED IN THE DESCRIPTION

### Patent documents cited in the description

- US 7224254 B
- US 20090134011 A
- US 5618388 A